# EUROPEAN PATENT APPLICATION

(11) **EP 4 357 795 A1**
(43) Date of publication of application: **24.04.2024**
(21) Application number: 23160741.7
(22) Date of filing: 08.03.2023
(51) Int. Cl.: G01R 31/319, G01R 31/28

(54) **DETACHABLE MODULARIZED TEST PLATFORM**

(30) Priority: 21.10.2022 CN 202211296737
(71) Applicant: Shenzhen Longood Intelligent Electric Co., Ltd., Shenzhen, Guangdong 523000 (CN)
(72) Inventor: LI, Jun Ming, Shenzhen, 523000 (CN); LUO, De Feng, Shenzhen, 523000 (CN); Qin, You Shan, Shenzhen, 523000 (CN); Huang, Jian Lin, Shenzhen, 523000 (CN); Liang, Yong, Shenzhen, 523000 (CN); Li, Cheng Chun, Shenzhen, 523000 (CN)
(74) Representative: Zaboliene, Reda

(57) **Abstract**

Disclosed is a detachable modularized test platform. The detachable modularized test platform includes a gantry, a control box and a jig box, where a test area is arranged on the jig box, an air cylinder is arranged on the gantry, a control assembly is mounted in the control box, and a test assembly is mounted in the jig box; during testing, a sample to be tested is placed on the test area, and the upper computer sends an instruction to control the air cylinder to extend a driving rod to move to the sample to be tested; and the upper computer sends the instruction to the control assembly in the control box, to complete testing of the sample, and output and upload test data to a server for saving. The present invention employs a modularized structure, which reduces a size, detection is convenient, and applicability is high.

## Description

### TECHNICAL FIELD

The present invention relates to a test platform, in particular to a detachable modularized test platform for testing of various types of components.

### BACKGROUND ART

Most products need a test before delivery, so as to ensure that properties satisfy the requirements for delivery. Testing a product requires a corresponding testing device.

The existing test platform, with a single structural shape, which is mostly a single structure, that is, the whole platform is of an integrated structure, has the problems of large size, large weight and inconvenient transportation.

Most existing test platforms are presented in a form of structures according to functional requirements of product use and are assembled as an entire apparatus finally. The apparatus in this form of structure is only suitable for a single product. In the face of other products, it is necessary to redesign a matching test apparatus, which has the problems of low utilization rate, high production cost and large storage space, and also increases the apparatus cost.

Moreover, more functional circuit boards need to be assembled in the current test platform in order to satisfy different test requirements. These functional circuit boards are generally directly assembled on an inner wall of the apparatus, and are finally connected by means of data lines or power lines. As for the apparatus in this form of structure, the circuit boards occupy a large space on the inner wall, the space layout is difficult, the need for a shape of the apparatus is large, the lines are complex, and the arrangement is difficult. Furthermore, the complex lines will further bring greater difficulties for the follow-up maintenance, which requires high technical capacity of the assembly personnel, and low assembly efficiency, high assembly difficulty, difficult maintenance and other problems exist.

### SUMMARY

In order to solve the above technical problem, the present invention provides a detachable modularized test platform.

In order to solve the above technical problem, the present invention uses the following technical solution:

A detachable modularized test platform includes a gantry, a control box and a jig box, where the jig box is mounted on a bottom of the gantry, the control box is mounted on a side of the gantry, a test area is arranged on the jig box, an air cylinder directly facing the test area is arranged on the gantry, a control assembly is mounted in the control box, and a test assembly is mounted in the jig box;
the control box is in communication connection with an upper computer by means of the control assembly, the control assembly is connected to the test assembly for transmitting a signal, during testing, a sample to be tested is placed on the test area of the jig box, and the upper computer sends an instruction to control the air cylinder to extend a driving rod to move to the sample to be tested; and the upper computer sends the instruction to the control assembly in the control box, to complete testing of the sample by providing different test conditions, and output and upload test data to a server for saving.

As a further improvement, the control assembly in the control box includes a main circuit board, a functional circuit board and an electrical control component, the electrical control component is connected to the main circuit board, the functional circuit board is in insertion connection to the main circuit board and an adapter circuit board by means of terminals separately, and the adapter circuit board is connected to the test assembly in the jig box; the functional circuit board includes:
an output power supply module board configured to supply an adjustable direct current (DC) voltage source to the sample to be tested or other users;
a synthesis module board configured to accommodate different test circuits;
a channel module board configured to connect a sample point signal of the sample to be tested to a sampling apparatus;
a driving module board configured to drive various types of components;
a signal module board configured to collect and analyze various analog signals, digital signals, and output corresponding signals;
a main control module board configured to control corresponding module boards to complete testing of the sample to be tested; and
a precision power supply module board configured to provide multi-channel independent direct current power outputs isolated from each other;
the main circuit board serves as a carrier for all modules, supplies power input to all module boards, and communicates with the upper computer; and
the adapter circuit board has several connection ports.

As a further improvement, the test assembly in the jig box is a conditional circuit board and a load, the conditional circuit board is configured to provide various different test conditions, the conditional circuit board is connected to the adapter circuit board by means of a flexible flat cable, and the flexible flat cable has a length greater than a spaced distance between the conditional circuit board and the adapter circuit board.

As a further improvement, a rear flip door is rotatably mounted on an upper surface of the jig box by means of a hinge, a front flip door is rotatably mounted on a front end of the jig box by means of a hinge, a recess is provided in the rear flip door, a wire groove is provided in a bottom surface of the control box, and the flexible flat cable on the adapter circuit board enters the jig box through the wire groove and the recess and is connected to the conditional circuit board.

As a further improvement, the conditional circuit board is locked in the jig box by means of screws, the conditional circuit board may be mounted or replaced by opening the front flip door of the jig box, so as to adapt to products with different test requirements by replacing different conditional circuit boards.

As a further improvement, the control box includes a box body, a guide rail assembly is arranged in the box body, the main circuit board is mounted on an inner side wall of the box body by means of screws, the functional circuit board is clamped on the guide rail assembly in a direction perpendicular to the main circuit board and is in insertion connection to the main circuit board by means of a terminal, and the adapter circuit board is in insertion connection to the functional circuit board by means of a terminal.

As a further improvement, the guide rail assembly includes an upper guide rail plate and a lower guide rail plate, the upper guide rail plate is mounted on a top surface of the box body, the lower guide rail plate is mounted on a bottom surface of the box body, the upper guide rail plate and the lower guide rail plate are each provided with several guide channels, and the functional circuit board is mounted along the guide channels, such that an upper side of the functional circuit board is inserted in the guide channels of the upper guide rail plate, and a lower side of the functional circuit board is inserted in the guide channels of the lower guide rail plate.

As a further improvement, a front end surface of the control box is provided with a front push-pull door, two sides of the control box are provided with heat dissipation holes, heat dissipation fans are arranged in the heat dissipation holes, and an upper slide cover is arranged on a top of the box body.

As a further improvement, the gantry includes a bottom plate and a support plate mounted on the bottom plate, a cross beam is arranged on the support plate, the air cylinder is mounted on the cross beam, a control box positioning pin and a jig box positioning pin are arranged on the support plate, a bottom surface positioning hole is provided in the control box, a jig positioning hole is provided in a bottom surface of the jig box, the control box positioning pin is inserted into the bottom surface positioning hole and then the control box and the support plate are locked together by means of screws, and the jig box positioning pin is inserted into the jig positioning hole and then the jig box is locked on the bottom plate by means of screws.

As a further improvement, the control box is internally provided with an upper cavity and a lower cavity separated from each other, the electrical control component is arranged in the upper cavity, and the guide rail assembly, the main circuit board, the functional circuit board, and the adapter circuit board are arranged in the lower cavity.

Compared with the prior art, the present invention has the following beneficial technical effects:
1. The whole device is divided into three modules of a gantry, a control box and a jig box, which are installed by means of screws, easy to disassemble, capable of being replaced separately and high applicability. By means of a reasonable assembly structure, that is, assembly of combination of the control box and the jig box, the device does not occupy a large space, such that the overall size may be smaller and weight may be reduced. The control box, the gantry, and the jig box may be packaged individually during delivery transport or storage, which effectively reduces a size and does not occupy large transport storage space, so as to save storage space and reduce costs.
2. The control box is internally provided with different functional circuit boards, to satisfy testing requirements of different products; by establishing communication connection between the main circuit board and the upper computer, an instruction may be output conveniently; and combined with a modularized function of the functional circuit board, the platform is applicable to various products, so as to greatly improve the utilization rate, interchangeability and versatility of the apparatus.
3. When different products need to be tested, the whole device does not need to be disassembled, and it is only necessary to open the jig box and replace a conditional circuit board in the jig box, which is convenient and fast and saves costs. The different circuit boards in the control box uses terminal inserting and discards traditional circuit connection, which may save the complicated circuit arrangement and welding and reduce the assembly difficulty between circuit boards, the assembly ability of technicians is undemanding, an error rate is reduced, and the device has greater universality and flexibility.
4. Since the control box and the jig box are mounted on the gantry individually, the control box and the jig box may be disassembled without using special apparatus tools, so as to facilitate subsequent maintenance and reduce maintenance difficulty.

### BRIEF DESCRIPTION OF THE DRAWINGS

FIG. 1 is a schematic diagram of a perspective structure according to the present invention;
FIG. 2 is a schematic diagram of an exploded structure according to the present invention;
FIG. 3 is a schematic structural diagram of a gantry according to the present invention;
FIG. 4 is a schematic diagram of a perspective structure of a control box according to the present invention;
FIG. 5 is a schematic diagram of a perspective structure of a jig box in an open state according to the present invention;
FIG. 6 is a schematic diagram of an exploded structure of a control box according to the present invention;
FIG. 7 is a schematic structural diagram of a functional circuit board according to the present invention;
FIG. 8 is a schematic structural diagram during testing according to the present invention;
FIG. 9 is a schematic structural diagram of a jig box internally having a load according to the present invention; and
FIG. 10 is a schematic diagram of a principle of communication connection according to the present invention.

### Reference numbers:

1-gantry; 101-bottom plate; 102-support plate; 103-cross beam; 104-control box positioning pin; 105-jig box positioning pin;
2-control box; 201-box body; 202-upper guide rail plate; 203-lower guide rail plate; 204-guide channel; 205-main circuit board; 206-functional circuit board; 2061-output power supply module board; 2062-synthesis module board; 2063-channel module board; 2064-driving module board; 2065-signal module board; 2066-main control module board; 2067-precision power supply module board; 207-adapter circuit board; 208-upper cavity; 209-lower cavity; 210-front push-pull door; 211-upper slide cover; 212-heat dissipation fan; 213-power supply; 214-solenoid valve; 215-bottom surface positioning hole;
3-jig box; 301-test area; 302-rear flip door; 303-front flip door; 304-handle; 305-jig positioning hole; 306-recess; 307-conditional circuit board; 308-load;
4-air cylinder; and 5-sample to be tested.

### DETAILED DESCRIPTION OF THE EMBODIMENTS

Embodiments of the present invention are described in detail below, instances of which are illustrated in the drawings, and like or similar reference numerals refer to the same or similar elements or elements having the same or similar function throughout. The embodiments described below by reference to the drawings are illustrative only for explaining the present invention and are not to be construed as limiting the present invention.

In the description of the present invention, it is to be understood that the involved terms "central", "longitudinal", "transverse", "length", "width", "thickness", "upper", "lower", "front", "back", "left", "right", "vertical", "horizontal", "top", "bottom", "inner", "outer", "clockwise", " counterclockwise", etc. indicate azimuthal or positional relations based on those shown in the drawings only for ease of description of the present invention and for simplicity of description, and are not intended to indicate or imply that the referenced device or element must have a particular orientation and be constructed and operative in a particular orientation, and thus may not be construed as limiting the present invention. In addition, the terms "first", "second" and so forth are for descriptive purposes only and are not to be construed as indicating or implying their relative importance or implicitly specifying the number of indicated technical features. Thus, a feature defined with "first" and "second" may explicitly or implicitly include at least one of the features. In the description of the present invention, "plurality" means two or more, unless expressly specified otherwise.

In the present invention, unless expressly specified otherwise, the terms "mount", "connect", "connected", etc. are to be construed broadly and, for example, may be fixedly connected, or detachably connected, or integrally connected, may mean a mechanical connection, or an electrical connection, may mean a direct connection, an indirect connection via an intermediary medium, a communication between interiors of two elements, or an interworking relation between two elements. Those of ordinary skill in the art may understand specific meanings of the foregoing terms in the present invention based on a specific situation.

### Example 1

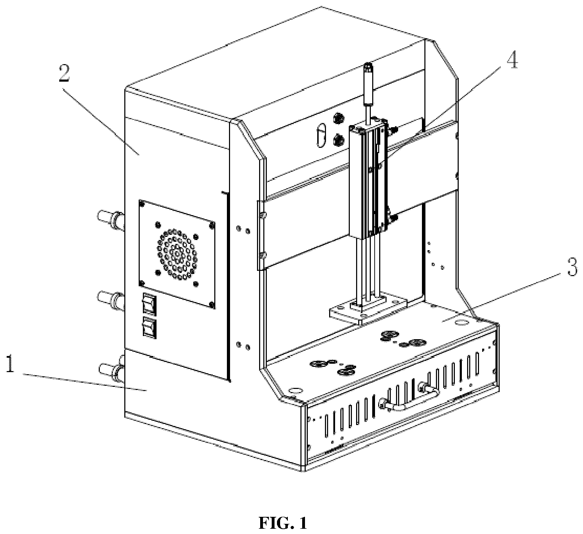

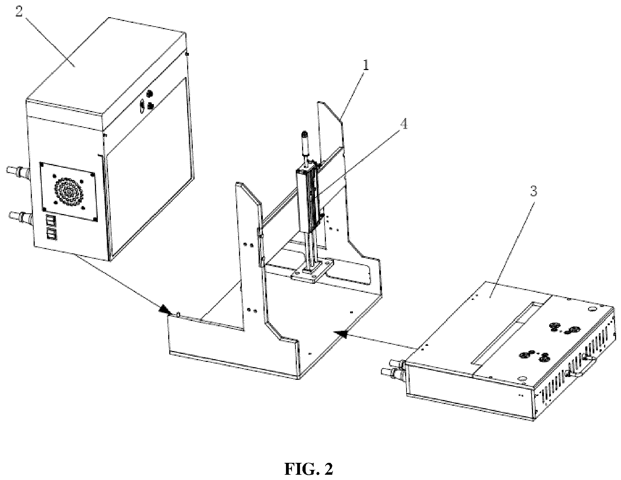

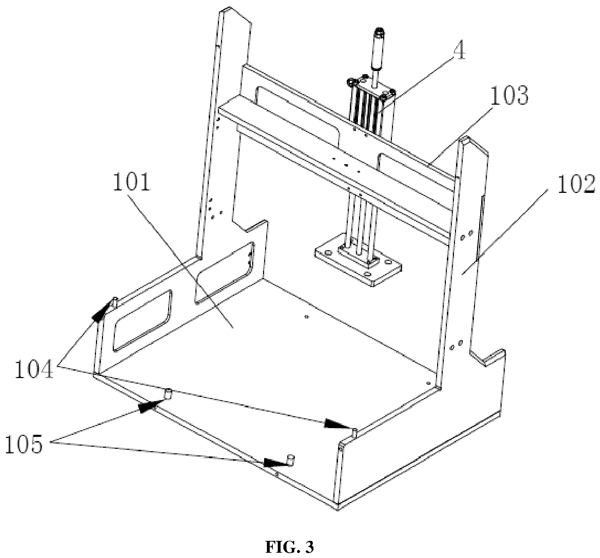

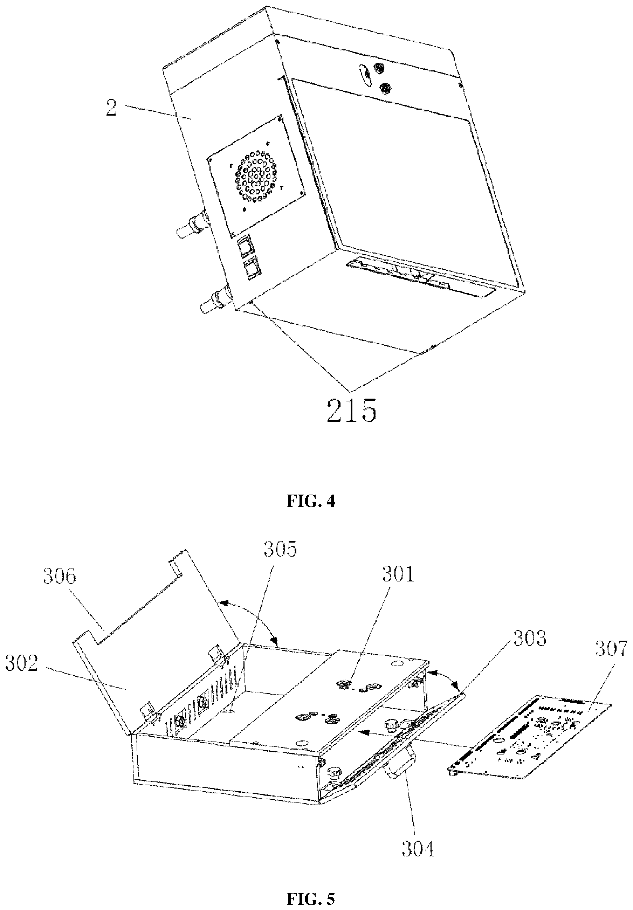

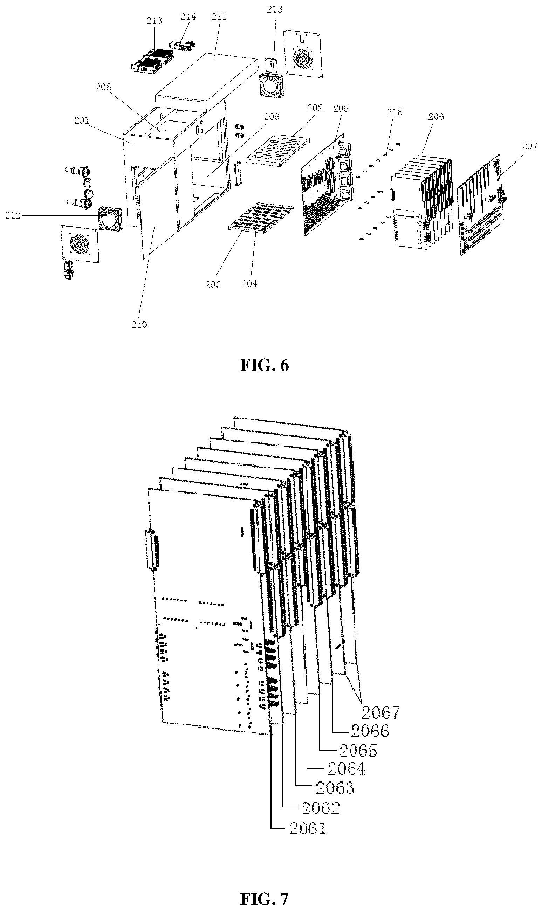

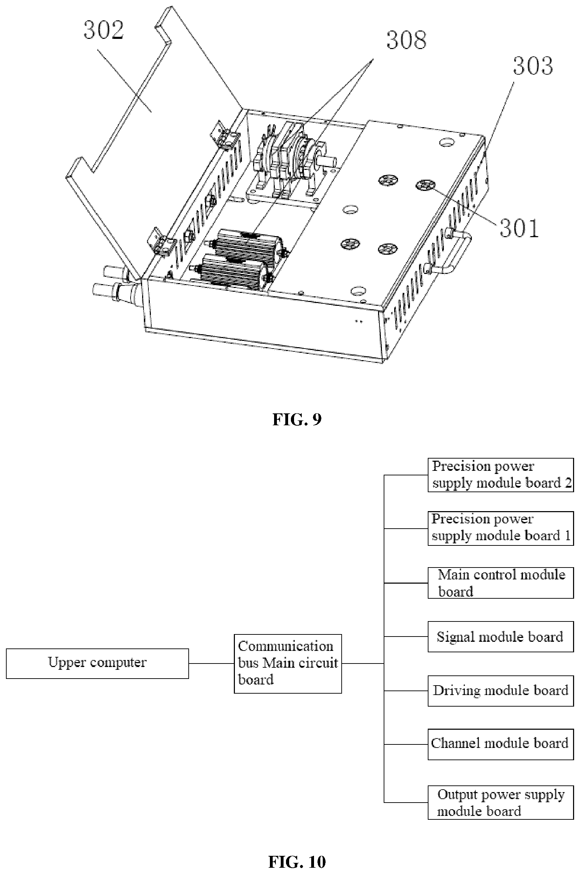

With reference to FIGs. 1-10, a detachable modularized test platform includes a gantry 1, a control box 2 and a jig box 3, where the jig box 3 is mounted on a bottom of the gantry 1, the control box 2 is mounted on a side of the gantry 1, a test area 301 is arranged on the jig box 3, an air cylinder 4 directly facing the test area is arranged on the gantry 1, a control assembly is mounted in the control box 2, and a test assembly is mounted in the jig box. By means of the above division, the whole platform is divided into three modules of a gantry, a control box and a jig box. The gantry serves as a support, to assemble the control box and the jig box. The control box serves as a control module, the control assembly arranged in the control box may provide a plurality of different test conditions so as to satisfy test requirements of different products. The jig box serves as a module making direct contact with a sample to be tested 5, as for different samples to be tested, only the test assembly in the jig box needs to be replaced, which improves universality of testing. The control box and the jig box are assembled compactly on the gantry, allowing the overall size to be small and space saving. The driving rod of the air cylinder is vertically downwards and may be connected to a corresponding component, so as to implement a contact test on the sample to be tested.

The control box is in communication connection with an upper computer by means of the control assembly, the upper computer may be a computer, a variety of application systems, or other smart control terminals, the control assembly is connected to the test assembly for transmitting a signal, during testing, the sample to be tested is placed on the test area of the jig box, and the upper computer sends an instruction to control a test component to move to the sample to be tested; and the upper computer sends the instruction to the control assembly in the control box, to complete testing of the sample by providing different test conditions, and output and upload test data to a server for storage.

The control assembly in the control box 2 includes a main circuit board 205, a functional circuit board 206 and an electrical control component, the electrical control component is connected to the main circuit board 205, the functional circuit board 206 is in insertion connection to the main circuit board 205 and an adapter circuit board 207 by means of terminals separately, and the adapter circuit board 207 is connected to the test assembly in the jig box 3. The insertion connection mounting is achieved by means of the terminals between the individual circuit boards, cumbersome line connection modes are eliminated, part of distribution in the control box may be more concise, difficulty of assembly is further reduced, the technical capacity of an operator is undemanding, and moreover, subsequent maintenance operation is facilitated.

The functional circuit board 206, providing functions required by various tests, may include a plurality of circuit boards. For example, the functional circuit board includes:
an output power supply module board 2061 configured to supply an adjustable direct current (DC) voltage source to the sample to be tested or other users, for example, various voltages of 110VAC/60HZ, 220VAC/50HZ to guarantee normal running of the module boards;
a synthesis module board 2062 configured to accommodate different test circuits, for example, a current test circuit, a voltage test circuit, or other types of circuits, where all of the circuits are well-known circuits, the structures of the circuits are not in the solution of the present invention, and different performance tests are implemented by providing different types of test circuits;
a channel module board 2063 configured to connect a sample point signal of the sample to be tested to a sampling apparatus, for example, a digital multimeter capable of clearly display for human viewing;
a driving module board 2064 configured to drive various types of components, for example, a solenoid valve, a relay, to implement connection or disconnection control over current, voltage, or a corresponding signal, such as to control an action of the air cylinder mounted on the gantry;
a signal module board 2065 configured to collect and analyze various analog signals, digital signals (for example, an amplitude, a period, duration of high and low electric frequencies, etc.), and output various common signals (for example, a square wave signal, a sine wave signal, a magnetic field signal, etc.);
a main control module board 2066 configured to control all other module boards by means of a communication bus to complete testing of the sample to be tested; and
a precision power supply module board 2067, where in the example, two precision power supply module boards are provided in total, are configured to provide multi-channel independent direct current power outputs isolated from each other, and mainly configured to supply power to a load having extremely high power supply ripple requirements (for example, an analog single lithium battery, etc.).

The main circuit board 205 serves as a carrier for all modules, supplies power input to all module boards, and communicates with the upper computer, and each module board uses the main circuit board as a relay of signals for corresponding functional control.

The adapter circuit board 207 has several connection ports for collecting and packaging external interfaces of the module boards, making them generalized and standardized, convenient and unified connection is achieved, and versatile is high.

The above-listed are some basic types of functional circuit boards. For each module board, the circuit provided on the module board is currently known, and the corresponding module board may be flexibly increased or decreased according to actual testing requirements. In general, more functional circuit boards are preset first, which allows for a wider range of applicability. The control box, as a fixed module, does not allow easy replacement, and functions are richer, to provide testing conditions for different products.

The test assembly in the jig box 3 is a conditional circuit board 307 and a load 308, the conditional circuit board 307 is configured to provide various different test conditions, the conditional circuit board 307 is connected to the adapter circuit board 207 by means of a flexible flat cable, and the flexible flat cable has a length greater than a spaced distance between the conditional circuit board and the adapter circuit board. The conditional circuit board is connected to the adapter circuit board by using a longer flexible flat cable, the flexible flat cable between the control box and the jig box is still connected and the test platform may still remain in powered operation when the control box is removed alone for a distance. The flexible flat cable connection mode is combined with the three separable structural modules, which is more convenient for detection in maintaining procedures. The load is a motor, resistance, etc., providing a corresponding load requirement for the sample to be tested. The conditional circuit board providing test conditions means that the test conditions used for assisting in test requirements are packaged in the conditional circuit board according to the test requirements for the sample to be tested, various test conditions (for example, various analog loads, switching signals, etc.) are provided for the test of the sample to be tested. The particular circuits on the conditional circuit board are also well-known circuits. Different circuit boards may be replaced for different test products to implement testing.

The main circuit board 205, the functional circuit board 206, and the adapter circuit board 207 in the control box 2 are fixed module circuit boards that are suitable for various different products and need no replacement again. The conditional circuit board in the jig box is a replaced module, changes corresponding conditional packaging according to the test requirements of a tested sample, that is, for different test products, only the conditional circuit board in the jig box needs to be replaced, such that the operation is simpler.

### Example 2

With reference to FIGs. 1, 2, 5, 7 and 10, a rear flip door 302 is rotatably mounted on an upper surface of a jig box 3 by means of a hinge, a front flip door 303 is rotatably mounted on a front end of the jig box 3 by means of a hinge, the rear flip door 302 and the front flip door 303 may be opened, and after opening, an internal structure of the jig box 3 may be seen, and a test component may be quickly maintained or replaced. A recess 306 is provided in the rear flip door 302, a wire groove is provided in a bottom surface of a control box 2, the control box 2 and the jig box 3 are both mounted on a gantry, the wire groove in the bottom surface of the control box is in overlapping communication with the recess in a top surface of the jig box, to form a channel structure, and the flexible flat cable between the adapter circuit board of the control box and the conditional circuit board of the jig box is connected by means of the channel structure.

In order to maintain stability when the front flip door 303 is closed, a snap structure is arranged between the front flip door and the front end surface of the jig box. Secure tightening of the front flip door is achieved by the snap structure when the front flip door is closed. The snap structure may be a clamp column on the front flip door and a clamp groove on the front end surface of the jig box, the clamp column and the clamp groove are in a tight fit, such that when the front flip door is closed, the clamp column is inserted into the clamp groove to achieve clamping. Or the snap structure may be other snap structure, which are not enumerated herein. Or other types of connection structures may be used, for example, a magnetically attractable structure, that is, magnets of dissimilar polarity are arranged on the front end surface of the jig box and the front flip door separately, the magnets are attracted by the magnetic force when the front flip door is closed, so as to achieve firm assembly together. With the above assembly structure, it is possible to firmly tighten the front flip door and a jig bar.

The conditional circuit board 307 is locked in the jig box 3 by means of screws, the conditional circuit board may be mounted or replaced by opening the front flip door 303 of the jig box, so as to adapt to products with different test requirements by replacing different conditional circuit boards.

As for the overall layout of the jig box, the top portion is divided into two parts, one part is the rear flip door 302 located at a rear side, and the other part is a test area 301 located at a front side. After the rear flip door is closed, a gap is formed between the recess on the rear flip door and the test area. The interior of the jig box corresponding to the test area is used for mounting a conditional circuit board, and moreover, a corresponding in-circuit tester is arranged. The setting of the front flip door mainly facilitates the assembly and maintenance and disassembly of the conditional circuit board. The arrangement of the rear flip door mainly facilitates the mounting and disassembly of a matching load in the jig box, such as a resistor, a motor, a display lamp, etc.

Further more, a handle 304 may be arranged on each of the front flip door and a back panel of the jig box, so as to facilitate the drawing and lifting of the jig box. Both the front flip door and the back panel are provided with evenly distributed air guide channels, which are conducive to heat dissipation, avoiding an excessive temperature in the jig box, and effectively dissipating heat.

### Example 3

With reference to FIGs. 1-4, and 6, the gantry 1 includes a bottom plate 101 and a support plate 102 mounted on the bottom plate 101, a cross beam 103 is arranged on the support plate 102, the air cylinder 4 is mounted on the cross beam 103, a control box positioning pin 104 and a jig box positioning pin 105 are arranged on the support plate 102, a bottom surface positioning hole 215 is provided in the control box 2, a jig positioning hole 305 is provided in a bottom surface of the jig box 3, the control box positioning pin 104 is inserted into the bottom surface positioning hole 215 and then the control box 2 and the support plate 102 are locked together by means of screws, and the jig box positioning pin 105 is inserted into the jig positioning hole 305 and then the jig box 3 is locked on the bottom plate 101 by means of screws. The bottom plate 101 and the support plate 102 in the gantry 1 may be assembled by means of screws, welded, or integrally formed. One support plate is arranged on each of two sides of the bottom plate. By using the control box positioning pin and the jig box positioning pin, Precise assembly may be guaranteed by first positioning and then locking mounting. Furthermore, since the jig box is directly assembled on the bottom plate, the jig positioning hole may be formed by providing a slot on the bottom surface of the jig box close to a back plate side, the slot extends to the back side of the jig box, and the jig box may be directly placed on the bottom plate and then pushed towards the jig box positioning pin, such that the jig box positioning pin enters the slot without being placed from top to bottom, which provides convenience of mounting operation.

The control box may be assembled first, and then the jig box may be mounted. The bottom surface of the control box just falls on the rear flip door of the jig box. In this case, the jig box needs to be pushed from one side of the bottom plate until the jig positioning hole is clamped by the jig box positioning pin, and then is locked by screws. Alternatively, the jig box may be mounted first, the jig box is assembled on the jig box positioning pin from top to bottom, such that the jig box positioning pin is inserted into the jig positioning hole, and the control box is mounted after the jig box is locked.

The control box 2 includes a box body 201, a guide rail assembly is arranged in the box body 201, the main circuit board 205 is mounted on an inner side wall of the box body 201 by means of screws 215, the functional circuit board 206 is clamped on the guide rail assembly in a direction perpendicular to the main circuit board 205, the functional circuit board 206 is in insertion connection to the main circuit board 205 by means of a terminal, and the adapter circuit board 207 is in insertion connection to the functional circuit board 206 by means of a terminal. The guide rail assembly includes an upper guide rail plate 202 and a lower guide rail plate 203, the upper guide rail plate 202 is mounted on a top surface of the box body 201, the lower guide rail plate 203 is mounted on a bottom surface of the box body 201, the upper guide rail plate 202 and the lower guide rail plate 203 are each provided with several guide channels 204, and the functional circuit board 206 is mounted along the guide channels 204, such that an upper side of the functional circuit board is inserted in the guide channels of the upper guide rail plate, and a lower side of the functional circuit board is inserted in the guide channels of the lower guide rail plate.

Mounting of the functional circuit board by the guide rail assembly greatly reduces difficulty of assembly of the functional circuit board and reduces assembly technical requirements for an operator. Moreover, by means of terminal insertion connection, connection between the main circuit board and the functional circuit board and between the functional circuit board and the adapter circuit board is achieved, communication of electrical signals is achieved, complicated power or data lines or a welding process on the line are not required, the direct insertion connection of the terminal is merely used, for example, an insertion port is provided in the main circuit board, a corresponding insertion terminal is arranged on the functional circuit board, and the insertion terminal is directly inserted into the insertion port, such that a plurality of lines do not need to be arranged in the box body, and the cleanliness in the box body is maintained. Since the lines are reduced, the difficulty of subsequent maintenance is also reduced.

For the main circuit board, the functional circuit board, and the adapter circuit board, the main circuit board and the adapter circuit board are fixed laterally, and the functional circuit board is assembled vertically, such that the overall structure is more compact, a space utilization rate in the box body is higher, and this arrangement between the different circuit boards is further conducive to heat dissipation during work running.

The upper guide rail plate 202 is locked to the box body 201 by means of a screw, the lower guide rail plate 203 is locked to the box body 201 by means of a screw, and the functional circuit board 206 only relies on clamping of the upper guide rail plate 202 and the lower guide rail plate 203, and does not need to additionally use a screw for locking. Furthermore, when being mounted, the functional circuit board only needs to be slid and pushed in along a guide channel, which is very convenient, and no additional fixing component is needed for fixing, and the cumbersome procedure of mounting a plurality of screws in the box body is also omitted, which effectively improves the assembly efficiency. All circuit boards are compactly integrated with each other, and tightly assembled on the control box for maintaining stable.

Furthermore, heat dissipation holes are further provided in a left side and a right side of the box body 201, and heat dissipation fans 212 are arrange in the heat dissipation holes. Heat in the box body may be dissipated more quickly by means of the heat dissipation fans 212.

Electrical connectors, switches, communication connectors, etc. may optionally be mounted on sides of the box body for convenient connection to external components.

A front push-pull door 211 is arranged on the front end surface of the box body, and a corresponding slot may be arranged on the box body for assembling the front push-pull door. Certainly, the front end of the box body 201 is of an open structure for opening and closing by the front push-pull door, and mounting and disassembling of the component in the box body may be facilitated by means of the front push-pull door. The front push-pull door has a "7"-shaped structure, so as to limit the upper, lower, front and rear of the box body, and to facilitate the push-pull opening left and right.

The box body 201 is internally provided with an upper cavity 208 and a lower cavity 209 separated from each other, the electrical component is arranged in the upper cavity 208, and the guide rail assembly, the main circuit board, the functional circuit board, and the adapter circuit board are arranged in the lower cavity 209. For example, a solenoid valve 214, a power supply 213, etc. are mounted in the upper cavity 208, two separate cavities are formed by dividing, the electrical components (for example, a power supply, and a solenoid) and the circuit boards are not all arranged in one cavity, separate mounting facilitates separate inspection and maintenance, and no influence on each other exists. The main circuit board may be connected to the electrical component mounted in the upper cavity by means of the top plate.

An upper slide cover 211 is further arranged on an upper portion of the box body 201, to facilitate covering and opening of the upper cavity 208, thereby providing convenience. A clamping groove structure may be arranged on the top of the box body, to cooperate with the upper slide cover, so as to implement stable sliding and limiting of the upper slide cover.

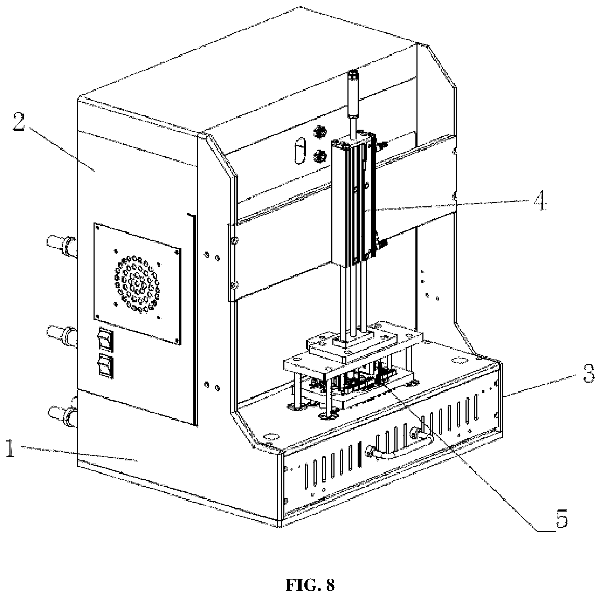

A particular test procedure of the present invention is as follows:
As shown in FIGs. 8 and 11, a sample to be tested is placed on a test area of a jig box, an upper computer is started, and a test task is started after obtaining an ID of the sample to be tested.

A main circuit board provides a communication bus for all module boards, and first sends a command to a driving module board by means of the communication bus to control an air cylinder to act. Then the communication bus sends the command to a signal module board, to detect position information about the air cylinder in real time. When it is detected that the air cylinder runs to a target position, the command is sent to the driving module board to stop driving the air cylinder and keep an air cylinder position fixed.

In this case, an output power supply module board is controlled by means of the communication bus to supply power required for various tests. Then the driving module board is controlled by means of the communication bus, to drive a switching action of various tests. Then the signal module board is controlled by means of the communication bus, to collect and provide signals required for various tests. A conditional circuit board is controlled by means of the communication bus, to provide test conditions required for various tests and upload measured data to a server for storage.

Finally, the upper computer and all module boards collaborate and interact with the test data by means of the communication bus to complete the test of the sample.

After the test is completed, the air cylinder is controlled to reset, and the product is removed.

In summary, the present invention mainly aims to provide a modularize test platform, which may test different products only by replacing the conditional circuit board in the jig box. The functional circuit board is assembled by using a guide rail assembly in the control box, the mounting difficulty is reduced, the assembly efficiency is improved, and the space utilization is improved.

It is to be noted that the foregoing is merely the preferred examples of the present invention and is not intended to limit the present invention, although the present invention has been described in detail with reference to the examples, for those ordinary skill in the art, the technical solutions described in the foregoing examples may be modified or equivalents may be substituted for some technical features thereof, but any modifications, equivalent substitutions, improvements, etc. made within the spirit and principles of the present invention should fall within the scope of protection of the present invention.

## Claims

1. A detachable modularized test platform, comprising a gantry, a control box and a jig box, wherein the jig box is mounted on a bottom of the gantry, the control box is mounted on a side of the gantry, a test area is arranged on the jig box, an air cylinder directly facing the test area is arranged on the gantry, a control assembly is mounted in the control box, and a test assembly is mounted in the jig box;
the control box is in communication connection with an upper computer by means of the control assembly, the control assembly is connected to the test assembly for transmitting a signal, during testing, a sample to be tested is placed on the test area of the jig box, and the upper computer sends an instruction to control the air cylinder to extend a driving rod to move to the sample to be tested; and the upper computer sends the instruction to the control assembly in the control box, to complete testing of the sample by providing different test conditions, and output and upload test data to a server for saving.

2. The detachable modularized test platform according to claim 1, wherein the control assembly in the control box comprises a main circuit board, a functional circuit board and an electrical control component, the electrical control component is connected to the main circuit board, the functional circuit board is in insertion connection to the main circuit board and an adapter circuit board by means of terminals separately, and the adapter circuit board is connected to the test assembly in the jig box; the functional circuit board comprises:
an output power supply module board configured to supply an adjustable direct current (DC) voltage source to the sample to be tested or other users;
a synthesis module board configured to accommodate different test circuits;
a channel module board configured to connect a sample point signal of the sample to be tested to a sampling apparatus;
a driving module board configured to drive various types of components;
a signal module board configured to collect and analyze various analog signals, digital signals, and output corresponding signals;
a main control module board configured to control corresponding module boards to complete testing of the sample to be tested; and
a precision power supply module board configured to provide multi-channel independent direct current power outputs isolated from each other;
the main circuit board serves as a carrier for all modules, supplies power input to all module boards, and communicates with the upper computer; and
the adapter circuit board has several connection ports.

3. The detachable modularized test platform according to claim 2, wherein the test assembly in the jig box is a conditional circuit board and a load, the conditional circuit board is configured to provide various different test conditions, the conditional circuit board is connected to the adapter circuit board by means of a flexible flat cable, and the flexible flat cable has a length greater than a spaced distance between the conditional circuit board and the adapter circuit board.

4. The detachable modularized test platform according to claim 3, wherein
a rear flip door is rotatably mounted on an upper surface of the jig box by means of a hinge, a front flip door is rotatably mounted on a front end of the jig box by means of a hinge, a recess is provided in the rear flip door, a wire groove is provided in a bottom surface of the control box, and the flexible flat cable on the adapter circuit board enters the jig box through the wire groove and the recess and is connected to the conditional circuit board.

5. The detachable modularized test platform according to claim 4, wherein the conditional circuit board is locked in the jig box by means of screws, the conditional circuit board can be mounted or replaced by opening the front flip door of the jig box, so as to adapt to products with different test requirements by replacing different conditional circuit boards.

6. The detachable modularized test platform according to claim 5, wherein the control box comprises a box body, a guide rail assembly is arranged in the box body, the main circuit board is mounted on an inner side wall of the box body by means of screws, the functional circuit board is clamped on the guide rail assembly in a direction perpendicular to the main circuit board and is in insertion connection to the main circuit board by means of a terminal, and the adapter circuit board is in insertion connection to the functional circuit board by means of a terminal.

7. The detachable modularized test platform according to claim 6, wherein the guide rail assembly comprises an upper guide rail plate and a lower guide rail plate, the upper guide rail plate is mounted on a top surface of the box body, the lower guide rail plate is mounted on a bottom surface of the box body, the upper guide rail plate and the lower guide rail plate are each provided with several guide channels, and the functional circuit board is mounted along the guide channels, such that an upper side of the functional circuit board is inserted in the guide channels of the upper guide rail plate, and a lower side of the functional circuit board is inserted in the guide channels of the lower guide rail plate.

8. The detachable modularized test platform according to claim 7, wherein a front end surface of the control box is provided with a front push-pull door, two sides of the control box are provided with heat dissipation holes, heat dissipation fans are arranged in the heat dissipation holes, and an upper slide cover is arranged on a top of the box body.

9. The detachable modularized test platform according to claim 8, wherein the gantry comprises a bottom plate and a support plate mounted on the bottom plate, a cross beam is arranged on the support plate, the air cylinder is mounted on the cross beam, a control box positioning pin and a jig box positioning pin are arranged on the support plate, a bottom surface positioning hole is provided in the control box, a jig positioning hole is provided in a bottom surface of the jig box, the control box positioning pin is inserted into the bottom surface positioning hole and then the control box and the support plate are locked together by means of screws, and the jig box positioning pin is inserted into the jig positioning hole and then the jig box is locked on the bottom plate by means of screws.

10. The detachable modularized test platform according to claim 9, wherein the control box is internally provided with an upper cavity and a lower cavity separated from each other, the electrical control component is arranged in the upper cavity, and the guide rail assembly, the main circuit board, the functional circuit board, and the adapter circuit board are arranged in the lower cavity.
